Europäisches Patentamt

European Patent Office

Office européen des brevets

(11) Numéro de publication : **0 636 895 A1**

(19)

## (12) DEMANDE DE BREVET EUROPEEN

(21) Numéro de dépôt : **94410055.1**

(51) Int. Cl.⁶ : **G01R 31/28**

(22) Date de dépôt : **26.07.94**

(30) Priorité : **30.07.93 FR 9309571**

(43) Date de publication de la demande :
**01.02.95 Bulletin 95/05**

(84) Etats contractants désignés :
**DE FR GB IT**

(71) Demandeur : **Vaucher, Christophe**
**40, Rue Génissieu**
**F-38000 Grenoble (FR)**

(72) Inventeur : **Vaucher, Christophe**
**40, Rue Génissieu**
**F-38000 Grenoble (FR)**

(74) Mandataire : **de Beaumont, Michel**
**1bis, rue Champollion**
**F-38000 Grenoble (FR)**

(54) **Grille de test pour testeur de circuit imprimé nu.**

(57) La présente invention concerne une grille de
test de circuit imprimé nu, comprenant des
points de test (T) reliés à des circuits de mesure.
Chaque circuit de mesure est relié à un groupe
(G) de points de test, les points de test de
chaque groupe étant reliés entre eux par des
résistances (r) de valeurs non nulles.

Fig 6A

EP 0 636 895 A1

La présente invention concerne les grilles de test utilisées dans des systèmes servant à mesurer la continuité des pistes d'un circuit imprimé nu ainsi que l'isolement d'une piste par rapport aux autres.

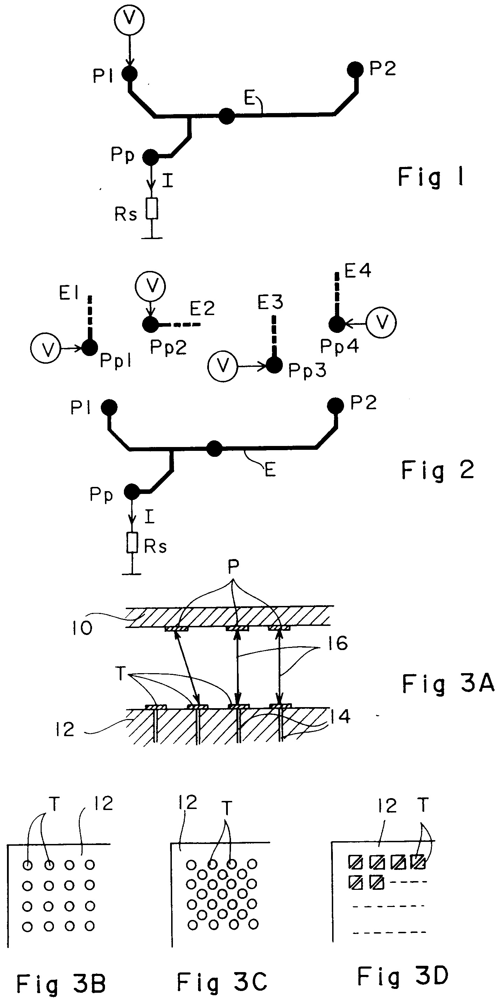

La figure 1 illustre un principe classique de mesure de la continuité d'une piste conductrice (équipotentielle) E existant sur un circuit imprimé nu à tester. La piste E comporte plusieurs ramifications qui se terminent par, ou comportent, des pastilles P dont l'une, choisie au hasard, est dite pastille principale $P_p$. La mesure de continuité consiste à mesurer les résistances présentes entre la pastille principale $P_p$ et chacune des autres pastilles ($P_1$, $P_2$). Pour cela, selon une méthode classique, la pastille principale $P_p$ est reliée à la masse par une résistance shunt Rs et une tension V est appliquée successivement aux pastilles P1, P2. Les résistances de continuité sont mesurées en mesurant le courant dans la résistance Rs.

La figure 2 illustre un principe classique de mesure d'isolement entre une piste E et d'autres pistes ou pastilles du circuit imprimé. La pastille principale $P_p$ de la piste E considérée est reliée à la masse par une résistance Rs. Ensuite, on applique successivement une tension V aux pastilles principales $P_p$1, $P_p$2... de chacune des autres pistes E1, E2... présentes sur le circuit imprimé, et on relève les courants correspondants dans la résistance Rs.

Généralement, toutes les mesures de continuité sont effectuées avant les mesures d'isolement.

Un circuit imprimé est considéré comme défectueux si, lors d'un test de continuité, on relève une résistance entre pastilles d'une même piste supérieure à un seuil de continuité généralement de l'ordre de 10 ohms ou si, lors d'un test d'isolement, on relève une résistance entre pastilles de pistes distinctes inférieure à un seuil d'isolement généralement de l'ordre de 10 Mohm.

Les figures 3A à 3C représentent des parties mécaniques classiques permettant de relier les pastilles P à un système de test.

Dans la figure 3A, un circuit imprimé à tester 10 comportant des pistes conductrices et des pastilles P, est posé sur un plateau de test 12 muni de pastilles de test T régulièrement réparties sur le plateau 12.

Chaque pastille P du circuit imprimé à tester est connectée à une pastille de test T, par exemple à l'aide d'une aiguille, ou "clou", 16. Les aiguilles 16 sont maintenues par un dispositif de guidage, non représenté, qui est dédié au circuit imprimé à tester. Un tel dispositif de guidage est fabriqué grâce à des informations pouvant être fournies par un logiciel qui associe chaque pastille à tester P à l'une des pastilles de test T. Les clous 16 (s'ils ne comportent pas eux-mêmes de ressorts) reposent généralement sur des pointes à ressort, non représentées, qui permettent de compenser les différentes inclinaisons des clous 16 et de fournir une force de contact. Dans certains systèmes, les pastilles de test T sont directement remplacées par des pointes à ressort. Ci-après, on appelle "point de test" tout élément (pastille de test T, pointe à ressort, clou 16) permettant d'établir un contact physique avec une pastille à tester P. L'ensemble des points de test est appelé grille de test. Cette grille est ou non organisée selon une structure géométrique régulière.

Les figures 3B à 3D représentent des configurations classiques de grille de test. La figure 3B représente une grille dite "simple densité" comprenant des points de test T disposés selon un pas de 2,54 millimètres (0,1 pouce). La figure 3C représente une grille dite "double densité" correspondant à deux grilles simple densité mais dont l'une est décalée par rapport à l'autre de 1,27 millimètres dans les sens latéral et longitudinal. La figure 3D représente un autre type de grille double densité, comprenant des pastilles carrées au pas de 2,54 mm, séparées en deux sous-pastilles selon une diagonale.

Pour que l'on puisse tester une zone de circuit imprimé prédéterminée, il est nécessaire de disposer à proximité de cette zone d'autant de points de test T que de pastilles à tester P. Toutefois, il ne faut pas qu'un point de test T soit trop éloigné de la pastille P à tester, ceci pour que l'inclinaison du clou 16 associé puisse toujours être compensée. Par conséquent, la densité des grilles de test est choisie en fonction de la densité du circuit imprimé à tester.

Chaque point de test T est relié par un conducteur 14 à un circuit de mesure "rapproché" qui est spécifique au point de test. Les informations fournies par chaque circuit rapproché sont multiplexées de manière qu'un système à microprocesseur puisse successivement exploiter ces informations. Le logiciel susmentionné connaît également la topographie des pistes du circuit imprimé, grâce à des informations qui permettent classiquement de fabriquer le circuit imprimé, ce qui lui permet de tester le circuit imprimé selon les étapes décrites en relation avec les figures 1 et 2 en sélectionnant à chaque mesure les circuits rapprochés correspondants.

Ainsi, dans l'art antérieur, un circuit de mesure rapproché est associé à chaque point de test. Le coût d'un circuit de mesure rapproché est relativement élevé, ce qui entraîne que le coût d'un système de test de circuit imprimé est pratiquement proportionnel au nombre de points de test.

Il existe des systèmes où deux points de test sont reliés directement à un seul circuit de mesure rapproché. Toutefois, en pratique, un seul des deux points de test doit être utilisé à la fois, car sinon, deux équipotentielles distinctes peuvent être court-circuitées, de manière que l'on ne puisse déterminer la résistance d'isolement entre ces équipotentielles.

Un objet de la présente invention est de prévoir une grille de test dont le coût par point de test utilisable est notablement réduit.

Pour atteindre cet objet, la présente invention propose de réduire le nombre de circuits rapprochés affectés à une grille de test de pas donné, en affectant un nombre prédéterminé de points de test à un seul circuit rapproché. Les points de test affectés à chaque circuit rapproché sont reliés entre eux par des impédances non nulles qui permettent au système de mesure de déterminer les résistances d'isolement et de continuité, quel que soit le point de test utilisé dans un groupe.

La présente invention vise plus particulièrement une grille de test de circuit imprimé comprenant des points de test reliés à des circuits de mesure. Chaque circuit de mesure est relié à un groupe de points de test, les points de test de chaque groupe étant reliés entre eux par des impédances de valeurs prédéterminées non nulles.

Selon un mode de réalisation de la présente invention, deux circuits de mesure sont reliés aux extrémités respectives de chaque groupe de points de test.

Selon un mode de réalisation de la présente invention, les groupes de points de test sont disposés selon des motifs réguliers.

Selon un mode de réalisation de la présente invention, les points de test comprennent des pastilles gravées sur un circuit imprimé, les pastilles de chaque groupe de points de test étant reliées ensemble par des résistances sérigraphiées sur le circuit imprimé ou montées en surface.

Selon un mode de réalisation de la présente invention, une partie au moins des circuits de mesure est réalisée sur une face dudit circuit imprimé selon la technologie des circuits hybrides ou de montage en surface.

Selon un mode de réalisation de la présente invention, les groupes de points de test sont disposés selon des "U" qui s'interpénètrent deux par deux.

Selon un mode de réalisation de la présente invention, les groupes de points de test sont disposés selon des lignes.

Ces objets, caractéristiques et avantages ainsi que d'autres de la présente invention seront exposés en détail dans la description suivante de modes de réalisation particuliers faite en relation avec les figures jointes parmi lesquelles :

la figure 1, précédemment décrite, illustre un principe classique de mesure de continuité de piste de circuit imprimé ;

la figure 2, précédemment décrite, illustre un principe de mesure classique d'isolement de piste de circuit imprimé ;

les figures 3A à 3D représentent une partie mécanique d'un système permettant de mesurer la continuité et l'isolement de pistes d'un circuit imprimé ;

la figure 4 représente une vue en coupe d'un mode de réalisation généralisé d'une grille de test selon la présente invention ;

les figures 5A à 5C représentent des configurations électriques obtenues lors de mesures effectuées avec une grille de test selon l'invention ; et

les figures 6A et 6B représentent des exemples de disposition de points de test selon l'invention.

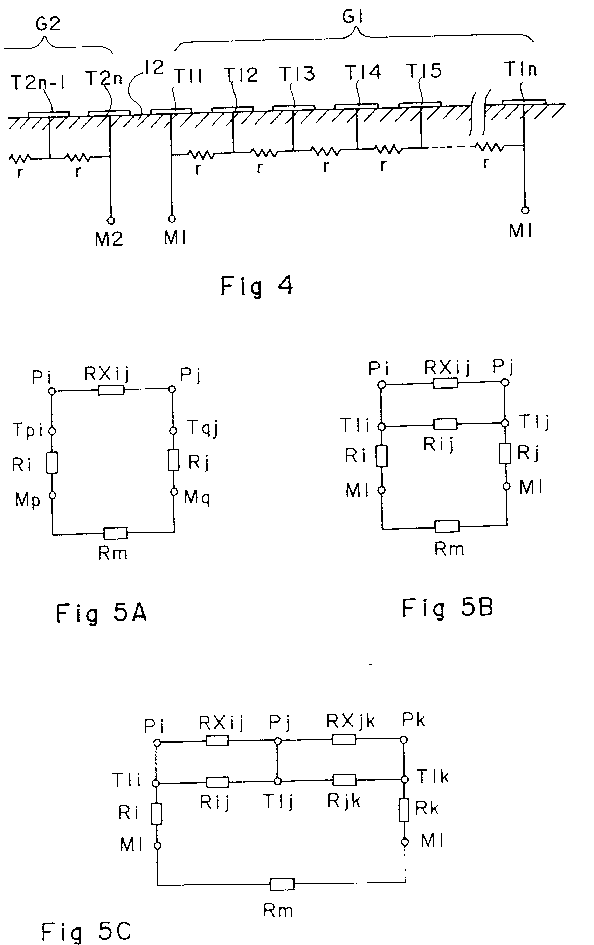

A la figure 4, selon un mode de réalisation de l'invention, les points T d'une grille de test sont rassemblés en groupes Gp (p=1, 2...) de n points Tp1, Tp2... Tpn. Chaque point T est relié au point suivant du même groupe par une résistance r de valeur précise choisie. De préférence, seuls deux points, par exemple le premier Tp1 et le dernier Tpn, d'un groupe sont reliés à deux circuits de mesure rapprochés respectifs par deux bornes Mp.

Ainsi, on ne trouve que deux circuits de mesure rapprochés pour n points, ce qui représente une diminution de coût d'un facteur n/2, environ, du système de test. Bien entendu, comme le système de test présente des coûts fixes et que les circuits de test sont un peu plus complexes pour exploiter une grille selon l'invention, ce facteur de réduction n'est pas tout à fait atteint. En pratique, par exemple pour n=8, le coût diminue d'un facteur 3 au lieu d'un facteur 4.

La figure 5A illustre une configuration électrique d'une grille de test selon l'invention lors d'un test de continuité ou d'isolement entre une pastille Pi reliée à un point de test Tpi et une pastille Pj reliée à un point de test Tqj. Les points Tpi et Tqj appartiennent à deux groupes Gp et Gq distincts (cette configuration est courante en test de continuité). La résistance de continuité ou d'isolement à trouver entre les pastilles Pi et Pj est notée RXij. On note Ri la somme des résistances r comprises entre le point Tpi et la borne Mp la plus proche, et Rj la somme des résistances r comprises entre le point Tqj et la borne Mq la plus proche. Le système de test mesure la résistance Rm présente entre les bornes Mp et Mq utilisées, les bornes Mp et Mq restantes étant mises en l'air.

Avec la configuration de la figure 5A, la résistance RXij cherchée s'exprime par :
$$RXij = Rm - Ri - Rj.$$

La figure 5B illustre une configuration où deux pastilles Pi et Pj à tester sont reliées à deux points T1i et T1j d'un même groupe G1 (cette configuration est courante en test d'isolement). On note Rij la somme des résistances r comprises entre les points T1i et T1j. Le système mesure la résistance Rm présente entre les deux bornes M1 du groupe G1. Dans ce cas, la résistance RXij cherchée s'exprime par :
$$RXij = (Rm - Ri - Rj)Rij/(Ri + Rj + Rij - Rm).$$

On rappelle que la résistance cherchée RX est normalement de valeur presque nulle en test de continuité et normalement de valeur très élevée en test d'isolement. Ainsi, si l'on effectue un test de continuité, la résistance mesurée Rm doit être proche de Ri+Rj, et si l'on effectue un test d'isolement, cette résistance mesurée doit être proche de Ri+Rj+Rij.

Toutefois, comme on l'a précédemment indiqué, un circuit imprimé est jugé bon si la résistance RX est inférieure à un seuil de continuité d'environ 10 ohms lors d'une mesure de continuité, et supérieure à un seuil d'isolement d'environ 10 Mohm lors d'une mesure d'isolement. Ainsi, les circuits de mesure de la résistance Rm doivent pouvoir déterminer si la résistance Rm est comprise entre Ri+Rj et une valeur légèrement supérieure ou si elle est comprise entre Ri+Rj+Rij et une valeur légèrement inférieure. Pour cela, de préférence, les résistances r sont grandes par rapport au seuil de continuité et petites par rapport au seuil d'isolement ; la précision du circuit qui mesure la résistance Rm détermine les valeurs que l'on peut utiliser pour les seuils. Plus le circuit de mesure est précis, plus le seuil de continuité pourra être choisi petit et le seuil d'isolement grand. En choisissant des résistances r de l'ordre de 1 kohm et des circuits de mesure classiques, on peut discerner un seuil de continuité d'environ 10 ohms et un seuil d'isolement d'environ 10 Mohm.

La figure 5C illustre une configuration où trois pastilles Pi, Pj et Pk à tester sont reliées à trois points de test respectifs T1i, T1j et T1k d'un même groupe G1. On note Rij la somme des résistances r comprises entre les points T1i et T1j, et Rjk la somme des résistances r comprises entre les points T1j et T1k (les points T1i et T1k étant les plus proches des bornes M1). On note RXij la résistance à trouver entre les pastilles Pi et Pj, et RXjk la résistance à trouver entre les pastilles Pj et Pk. Le système mesure la résistance Rm présente entre les deux bornes M1 du groupe G1.

Cette configuration apparait premièrement en test de continuité lorsque les trois pastilles Pi à Pk appartiennent à une même piste, ce qui est exceptionnel. Une solution simple pour déterminer l'état de la piste est d'effectuer une approximation en tenant compte du fait que les résistances Rij et Rjk sont normalement grandes devant les valeurs RXij et RXjk. La somme des résistances cherchées s'exprime alors par :

$$RXij + RXjk = Rm - Ri - Rk.$$

Si le résultat est inférieur au seuil de continuité, on est sûr que la piste testée est bonne.

Il n'est pas possible de déterminer directement les résistances RXij et RXjk par calcul. Une solution pour les déterminer de façon précise consiste à procéder par itérations successives en affectant des valeurs aux résistances RXij et RXjk et en comparant la résistance Rm mesurée à la valeur de la résistance Rm calculée en fonction des valeurs données aux résistances RXij et RXjk.

La configuration de la figure 5C apparait deuxièmement, et exceptionnellement, en test d'isolement lorsque deux pastilles, par exemple Pi et Pj, appartiennent à une première piste, la pastille Pk à une deuxième piste, et que la pastille Pk ou l'une des pastilles Pi et Pj est une pastille principale, c'est-à-dire (voir description de la figure 2) une pastille qui est mise à un potentiel fixe (la masse) pendant que l'on connecte d'autres pastilles à tour de rôle à un autre potentiel (V). La valeur de la résistance RXij a normalement été trouvée lors des tests de continuité, qui sont effectués avant les tests d'isolement. La résistance RXjk est alors calculée en fonction de la valeur de la résistance RXij qui aura été mémorisée.

La configuration de la figure 5C apparait troisièmement, et encore plus exceptionnellement, en test d'isolement lorsque les pastilles Pi à Pk appartiennent à des pistes distinctes, et que les trois pastilles sont des pastilles principales, ce qui est particulièrement exceptionnel. Une solution simple pour déterminer l'isolement entre les pistes est alors d'effectuer une approximation en supposant que le point T1j et la pastille Pj ne sont pas reliés. La somme des résistances cherchées s'exprime alors par :

$$RXij + RXjk = (Rm - Ri - Rk)(Rij + Rjk)/(Ri + Rk + Rij + Rik - Rm).$$

Si le résultat est inférieur au seuil d'isolement, on est sûr que l'isolement entre les pistes concernées est mauvais. Bien entendu, on peut également procéder par itérations, comme cela a été décrit pour le test de continuité.

Les cas que l'on vient de décrire en relation avec la figure 5C peuvent être facilement généralisés aux cas extrêmement exceptionnels où plus de trois pastilles à tester sont reliées à un même groupe de points de test.

Pour optimiser l'affectation des points de test aux pastilles à tester, c'est-à-dire pour que les configurations de mesure correspondent le plus souvent possible aux figure 5A ou 5B, un programme d'affectation tente d'abord d'affecter une seule pastille de circuit imprimé à chaque groupe de points de test, ce qui n'est en pratique possible que pour des circuits imprimés de densité moyenne. Si cette tentative échoue, le programme tente d'affecter une deuxième pastille à tester à chaque groupe, en tentant en même temps de ne pas affecter plus d'une pastille principale par groupe...

Le programme évitera en tout cas, pour un même groupe de points de test, d'encadrer un point de test affecté à une première piste par deux points de test affectés tous les deux à une deuxième piste, ce qui diminuerait considérablement la précision de mesure des résistances d'isolement entre les première et deuxième pistes.

Pour obtenir une affectation optimisée, il convient de réaliser une grille de test avec une répartition judicieuse des groupes de points de test, de manière que de nombreuses pastilles principales puissent être affectées à des groupes distincts.

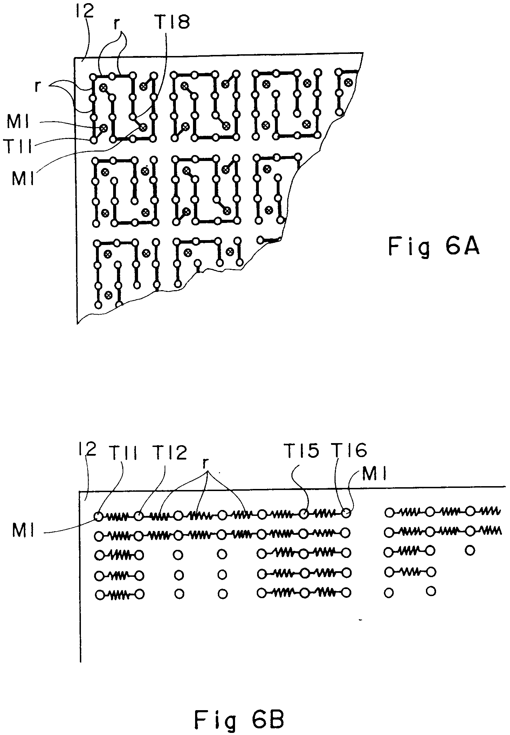

La figure 6A représente un exemple d'une telle grille de test. Cette grille est, par exemple, au pas de 1,27 mm. Les points de test sont regroupés huit par huit sur un plateau 12 selon des motifs en forme de "U" (une branche de chaque U étant plus courte que l'autre, comme le montre la figure). Les U sont disposés par paires dans des carrés de 4 points de côté. Les U de chaque paire sont disposés symétriquement selon une symétrie centrale de manière qu'ils s'interpénètrent. Le réseau des bornes M permettant de connecter chaque groupe de points de test est représenté par des cercles comportant une croix. Chacune des bornes M est disposée à proximité d'une extrémité respective du groupe de points de test associé.

On réalise, dans l'exemple de la figure 6A, une grille de test "quadruple densité" avec le nombre de circuits de mesure rapprochés qu'il faudrait pour une grille simple densité.

La figure 6B représente un autre exemple de grille de test selon l'invention. Les pastilles de chaque groupe sont alignées selon un pas choisi, et les groupes sont juxtaposés selon un pas moitié.

Le plateau de test 12 est formé, par exemple, d'un substrat multi-couches, tel que du verre époxy, sur une face duquel sont gravées des pastilles de test T. Les résistances r reliant les pastilles T d'un groupe, sont par exemple formées par sérigraphie sur l'une des couches du substrat ou sont des résistances à monter en surface (CMS). Les circuits de mesure rapprochés sont, par exemple, réalisés selon la technologie des circuits hybrides sur une autre face du substrat ou selon la technologie de montage en surface.

La présente invention est susceptible de nombreuses variantes et modifications qui apparaitront à l'homme du métier qui pourra, par exemple, donner des valeurs quelconques, éventuellement distinctes, aux résistances r.

## Revendications

1. Grille de test de circuit imprimé comprenant des points de test (T) reliés à des circuits de mesure, caractérisée en ce que chaque circuit de mesure est relié à un groupe (G) de points de test, les points de test de chaque groupe étant reliés entre eux par des impédances (r) de valeurs prédéterminées non nulles.

2. Grille de test selon la revendication 1, caractérisée en ce que deux circuits de mesure sont reliés aux extrémités respectives (M) de chaque groupe de points de test (T).

3. Grille de test selon la revendication 1, caractérisée en ce que les groupes de points de test (T) sont disposés selon des motifs réguliers.

4. Grille de test selon la revendication 1, caractérisée en ce que les points de test (T) comprennent des pastilles gravées sur un circuit imprimé (12), les pastilles de chaque groupe de points de test étant reliées ensemble par des résistances (r) sérigraphiées sur le circuit imprimé.

5. Grille de test selon la revendication 4, caractérisée en ce qu'une partie au moins des circuits de mesure est réalisée sur une face dudit circuit imprimé (12) selon la technologie des circuits hybrides.

6. Grille de test selon la revendication 1, caractérisée en ce que les points de test (T) comprennent des pastilles gravées sur un circuit imprimé (12), les pastilles de chaque groupe de points de test étant reliées ensemble par des résistances (r) montées en surface sur le circuit imprimé.

7. Grille de test selon la revendication 4, caractérisée en ce qu'une partie au moins des circuits de mesure est réalisée sur une face dudit circuit imprimé (12) selon la technologie de montage en surface.

8. Grille de test selon la revendication 3, caractérisée en ce que les groupes de points de test sont disposés selon des "U" qui s'interpénètrent deux par deux.

9. Grille de test selon la revendication 3, caractérisée en ce que les groupes de points de test sont disposés selon des lignes.

Fig 1

Fig 2

Fig 3A

Fig 3B

Fig 3C

Fig 3D

Fig 4

Fig 5A

Fig 5B

Fig 5C

Fig 6A

Fig 6B

**Office européen des brevets**

# RAPPORT DE RECHERCHE EUROPEENNE

Numero de la demande

**EP 94 41 0055**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A | US-A-5 006 808 (WATTS) ----- | | G01R31/28 |
| | | | **DOMAINES TECHNIQUES RECHERCHES (Int.Cl.6)** |
| | | | G01R |

Le présent rapport a été établi pour toutes les revendications

| Lieu de la recherche | Date d'achèvement de la recherche | Examinateur |
|---|---|---|
| LA HAYE | 16 Septembre 1994 | Hoornaert, W |

**CATEGORIE DES DOCUMENTS CITES**

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
........................................................................
& : membre de la même famille, document correspondant

EPO FORM 1503 03.82 (P04C03)